Europäisches Patentamt

European Patent Office

Office européen des brevets

(11) Publication number: **0 317 122**
**A2**

## EUROPEAN PATENT APPLICATION

(21) Application number: 88310293.1

(22) Date of filing: 02.11.88

(51) Int. Cl.4: **G11C 8/00 , G11C 11/40**

(30) Priority: 20.11.87 US 123503

(43) Date of publication of application:
24.05.89 Bulletin 89/21

(84) Designated Contracting States:
DE FR GB

(71) Applicant: **International Business Machines Corporation
Old Orchard Road
Armonk, N.Y. 10504(US)**

(72) Inventor: **Mao, Robert Shu
1168 Valley Quail Circle
San Jose, CA 95120(US)**

(74) Representative: **Hobbs, Francis John
IBM United Kingdom Limited Intellectual
Property Department Hursley Park
Winchester Hampshire SO21 2JN(GB)**

(54) **A static random access memory.**

(57) A static random access memory includes an array of memory cells (MC) connected to a pair of bit lines (eg, BL1, $\overline{BL1}$). Selection of a memory cell is performed by decoding an address using a dynamic address decoder (8,9). The bit lines and the decoder are restored to respective predetermined voltage levels. Restoration of the dynamic decoder is performed during the sensing of memory data; and restoration of the bit lines is performed before or during address decoding.

FIG. 1

EP 0 317 122 A2

# A STATIC RANDOM ACCESS MEMORY

The present invention relates to a static random access memory.

The two most commonly used criteria for evaluating the performance of a random access memory (RAM) device have been its access time and its cycle time. The access time of a RAM device can be defined as the interval between the instant at which an operation is requested and the instant at which the request is satisfied (e.g. data is ready to be accessed). In other words, access time is a measure of a memory device's response time. The cycle time of a memory is defined as the duration of a memory operation. It also defines how fast successive memory operations can be started.

In conventional semiconductor memory devices, memory cells are configured into a matrix, with each column of cells connected to a pair of bit lines. A memory cell is selected by decoding a given address into a row selection signal which causes a corresponding row of cells to transfer their content onto their respective bit lines. From the bit lines the data on one pair of bit lines is selected by a column selection signal generated by further decoding the given address.

To improve access time, many semiconductor memory devices employ dynamic type decoder circuits to speed up address decoding. A dynamic type decoder is composed of multiple NOR gates each having a single transistor level.

As memory size expands, the size of its decoder, and consequently the number of NOR gates connected to the address lines, will expand. This in turn would increase the decoder's accumulated capacitance. To reduce capacitive delay, decoders in many semiconductor memory designs are restored (i.e. to precharge them to predetermined voltage levels) during each memory cycle to improve their switching speed.

Restoration is also performed on the bit lines to ensure that unselected memory cells would not be disturbed in memory access, and/or to enable the bit lines to switch faster.

Because restoration of a dynamic decoder destroys its output, prior art RAM designs perform the restoration only after memory data has been sensed, at which time the accessed data would have already been latched.

If restoration of either the decoders or the bit lines is performed before data sensing, memory access time would be degraded. But if restoration is performed after data sensing, its cycle time would expand.

This invention seeks to provide a static random access memory device wherein improved access time is achieved without degrading its cycle time.

The invention provides a static random access memory having an array of memory cells connected to a pair of bit lines wherefrom data is sensed by sensing means, the memory being characterised by comprising dynamic decoding means for decoding an address to select a desired memory cell; means for restoring the decoding means to a predetermined voltage level during the sensing of data; and means for restoring the bit lines before completion of the address decoding.

How the invention can be carried out will now be described by way of example, with reference to the accompanying drawings, in which:-

Fig. 1 is a block diagram of a memory embodying the present invention;

Fig. 2A is a schematic illustration of the clock generator in the memory of Fig. 1;

Fig. 2B is a timing diagram illustrating the clock pulses generated from the clock generator.

Fig. 3 is a schematic diagram of the address decoder in the memory of Fig. 1;

Fig. 4A is a schematic diagram of the bit line precharge circuit in the memory of Fig. 1;

Fig. 4B is a timing diagram showing the relationships between the clock signals and the precharge signals;

Fig. 5 is a schematic circuit diagram of the sense amplifier in the memory of Fig. 1; and

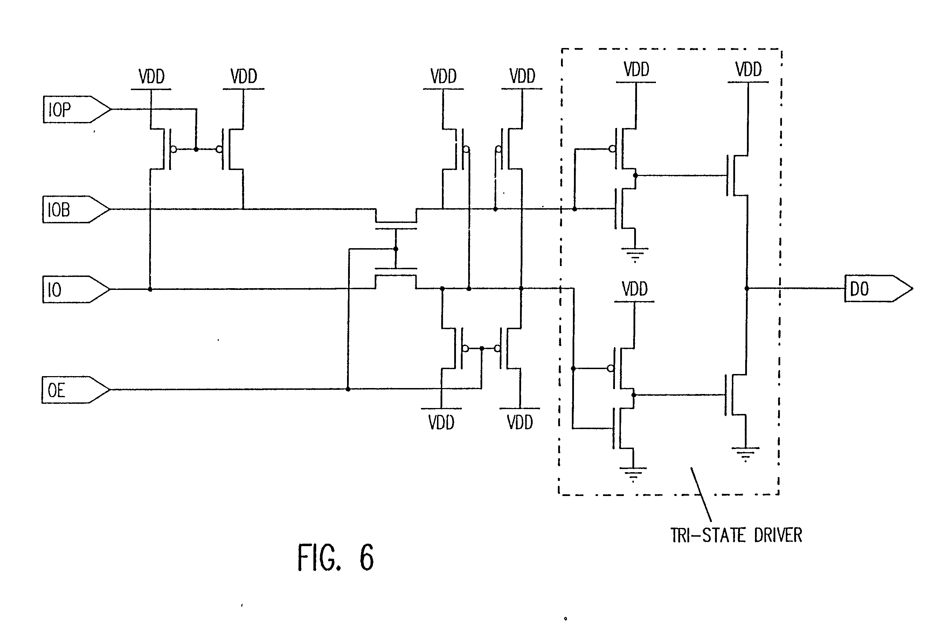

Fig. 6 is a schematic circuit diagram of an output driver of the memory of Fig. 1.

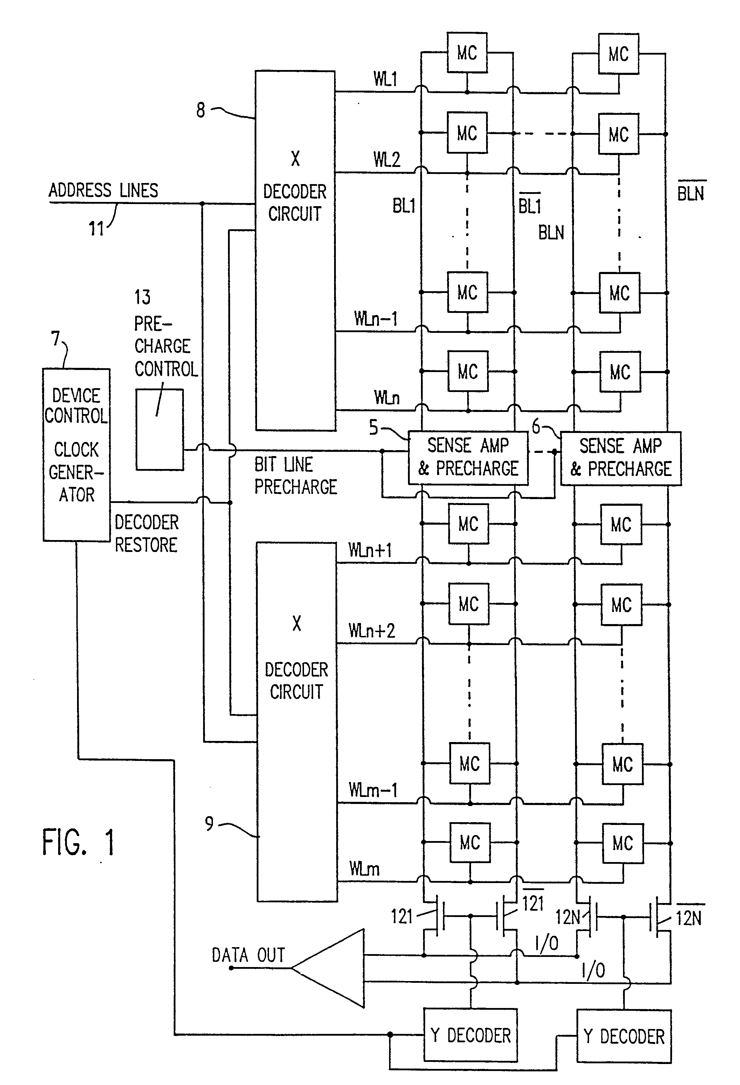

Fig. 1 is a block diagram of a static random access memory wherein the memory cells (MC) are arranged in a matrix. The cells of each column of memory cells share a pair of bit lines (BL1 and BL1). Data of a memory cell is transferred to its bit lines upon activation of a word line (WL) to which the memory cell is connected. The word lines are activated by a plurality of X-decoder circuits through the decoding of input address lines 11. The bit lines are connected, through respective pairs of n-channel field effect transistor (FET) gates 12, $\overline{12}$, to a pair of input/output lines (I/O). At each read operation, a pair of transistor gates 12, $\overline{12}$ are opened by the y-decoder to allow a selected pair of bit lines to connect and transfer the content thereof to the I/O lines. The I/O lines, in turn, transfer the data to an external system, such as a data processor, to which the memory device is attached.

Each bit line is connected to a voltage source VDD via a precharge gate for precharging it to a preset voltage level. The precharging is controlled by a signal generated from the precharge control circuit 13. Precharge control circuit 13, along with the X-decoder circuit and the Y-decoder circuit, receive timing signals from the clock generator.

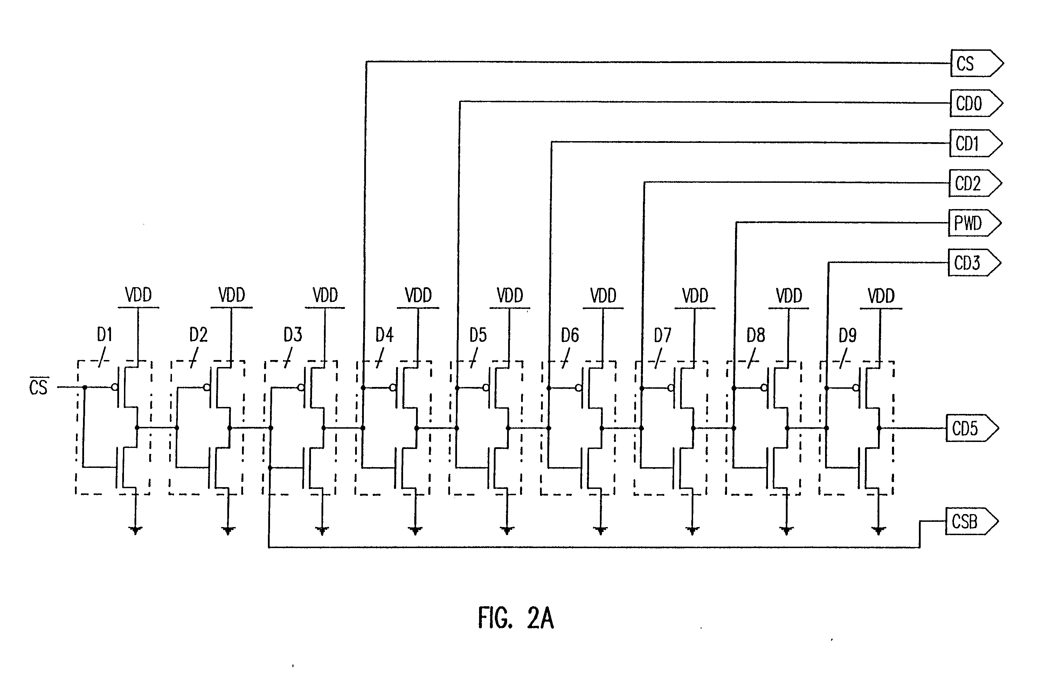

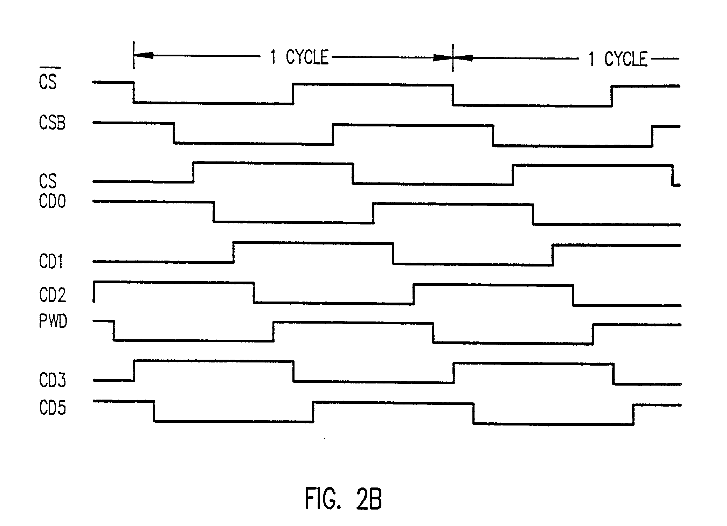

Fig. 2A is a schematic illustration of the clock generator. An external synchronisation signal $\overline{CS}$, commonly referred to as the "chip select signal", is received by the clock generator. The signal $\overline{CS}$ is fed through delay circuitry which comprises transistor pairs D1, D2,....D9 Each of these transistor pairs is composed of a n-channel FET connected in series with a p-channel FET. Because each transistor pair causes a circuit delay, there exists a phase difference between its output and input signals. Although not necessary in the general implementation, a signal is also inverted by each transistor pair of the delay circuit. The timing relationship of the internal chip select signal $\overline{CS}$, address decoder restore signal PWD, and clock signals CSB, CD0,...,CD5, all generated from the clock generator, is illustrated in Fig. 2B.

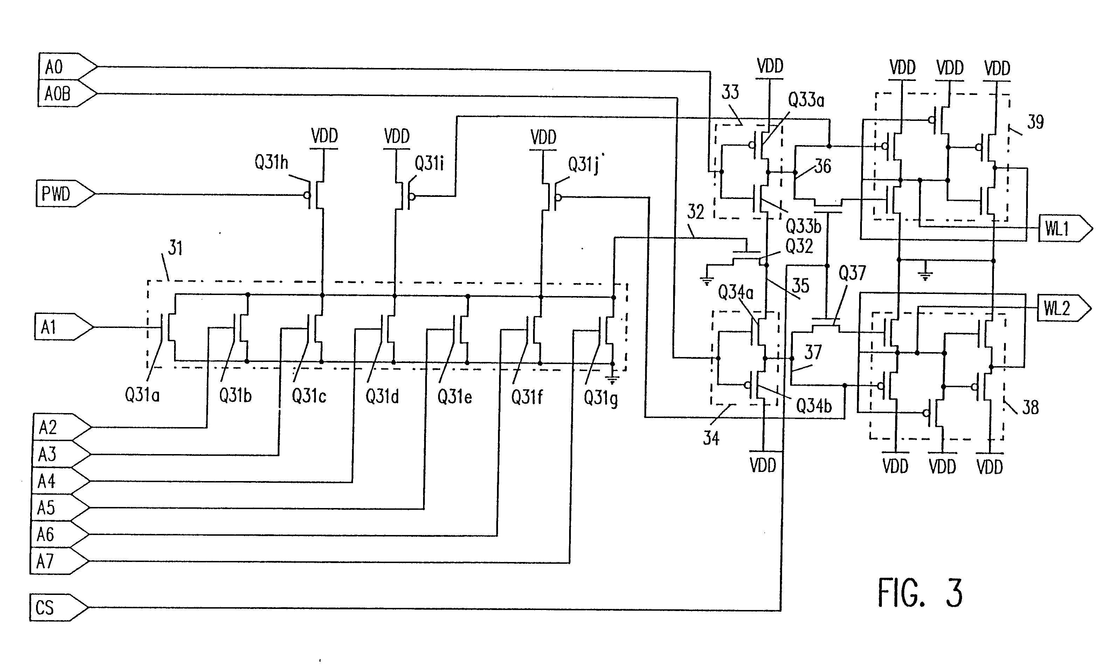

Fig. 3 is a schematic diagram of an address decoder circuit. It includes a dynamic type decoder 31 receiving external address lines A1, A2,....A7 and decoding the lines by way of a NOR function. When the received address bits match the wired address of the decoder, a "LOW" logic level signal would appear at each of n-channel transistor gates Q31a,...Q31f, causing these transistors to shut off, and resulting in a "HIGH" logic level at node 32, and a "LOW" logic level at node 35.

To reduce delay due to accumulated capacitive loading on gates Q31a,..,Q31g, node 32 is precharged. The precharging is performed under the control of the address decoder restore signal PWD through its control of p-channel transistor gate Q31h.

With continued reference to the decoder circuit of Fig. 3, lines A0 and A0B are used to select either an odd row or an even row of cells by activating one of the transistor blocks 33 or 34. Each of these blocks consists of a p-channel transistor connected in series with an n-channel transistor. If A0 is "HIGH", for example, A0B would be"LOW", thereby causing transistor gates Q33b and Q34b to turn on and transistor gates Q33a and Q34a to shut off. This then results in a "LOW" level at node 36 and a "HIGH" level at node 37.

The respective logic levels of nodes 36 and 37 are fed back to node 32 through a pair of p-channel transistors Q31i and Q31j. The purpose of this feedback is to maintain the logic level of node 32 in the presence of circuit leakage. This feedback is not necessary in the general implementation, but is used to facilitate diagnosis of an external system. During such diagnosis, operation of the memory may be suspended for a long period.

Referring again to Fig. 3, when chip select signal CS is active, the logic levels of nodes 36 and 37 will be transferred to "driver and latch" blocks 38 and 39 respectively. Word line signals WL1 and WL2 are the outputs of "driver and latch" blocks 38 and 39. Because the result of the dynamic decoder has been latched in blocks 38 and 39, it is apparent that precharging of the decoder would not affect the result of address decoding.

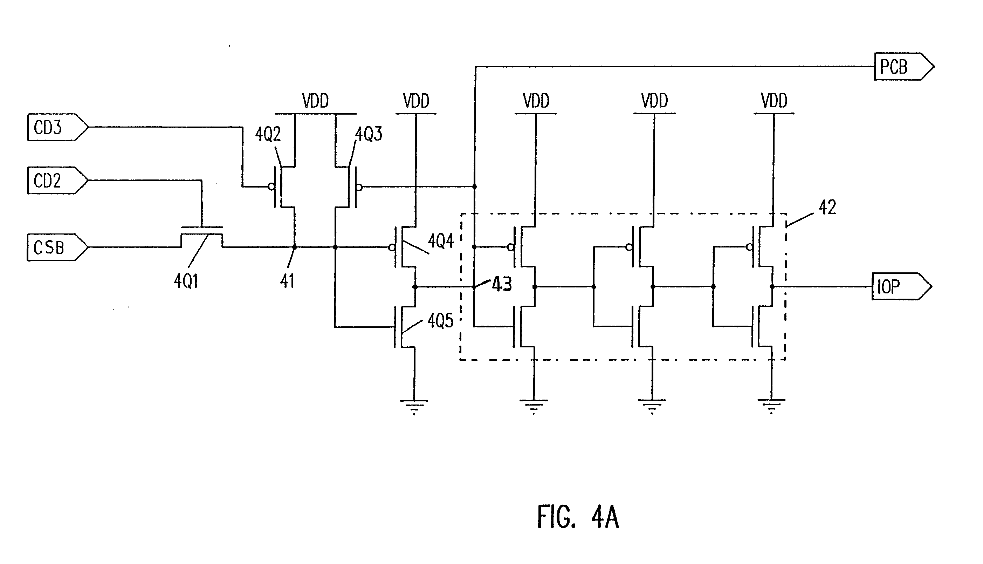

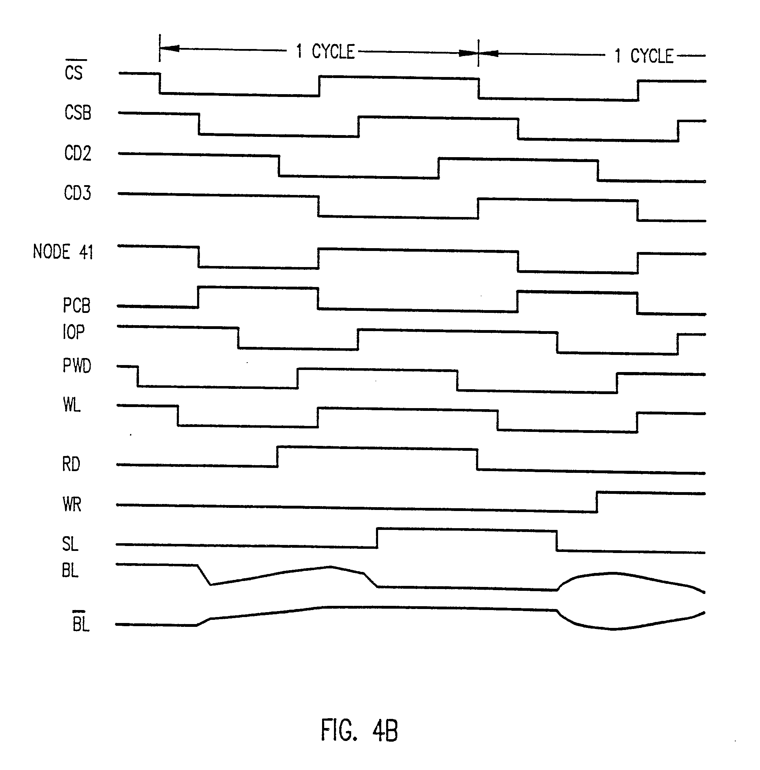

The operation of the bit line precharge circuit will now be described with reference to figs. 4A and 4B. The precharge circuit is designed so that the precharge bit line signal is a narrow pulse with sharp rising and falling edges.

With reference to Fig. 4A, clock signal CSB is gated through an n-channel transistor 4Q1 under the control of clock signal CD2. The gated signal, at node 41, is pulled high through a p-channel transistor 4Q2 by a third clock signal CD3. The signal at node 41 drives a p-channel transistor 4Q4 and an n-channel transistor 4Q5. Since there is no device connected in series with 4Q5 and no device connected in parallel to 4Q4, the signal at node 43 has sharp rising and falling edges. Although not necessary in the general case, p-channel transistor 4Q3 is a feedback path used to maintain the logic level of node 41 in case of transistor leakage. Signal IOP (1/0 precharge) is delayed from signal PCB (Precharge bit line) by a series of inverter stages in a block 42 because IOP is also used to activate the Y decoder. Fig. 4B is a timing diagram showing the occurrences of the above described signals.

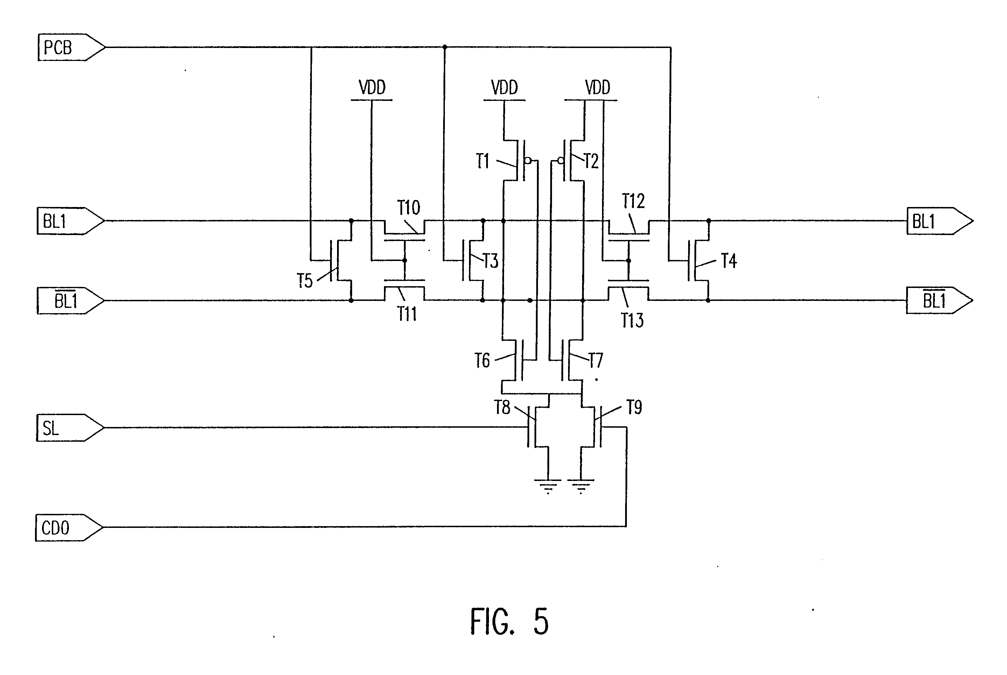

The operation of a sense amplifier is now described with reference to Fig. 5 to complete the description of the memory.

The sense amplifier comprises a p-channel amplifier (T1 and T2), a n-channel amplifier (T8 and T9), three n-channel bit line equalising devices (T3, T4 and T5) and two pairs of bit line load isolation devices (T10 and T11, T12 and T13).

The p-channel amplifier, consisting of T1 and T2, is responsible for bit line precharging during bit line restoration. When signal PCB is active, the n-channel equalising devices T3, T4 and T5 are turned on, pulling the bit lines from VDD to VT, which is the threshold voltage of a FET device, or from ground to (VDD-VT)/2, depending on the original state of a bit line. As long as the voltage of a bit line is lower than VDD-VT, both T1 and T2 are on and slowly precharge the bit lines to VC, which is a voltage greater than VDD/2 but less than VDD-VT.

The p-channel amplifier is also responsible for bit line voltage restoration during data sensing. When the n-channel amplifier is set by a set latch (SL) signal, transistor T6 (or T7) will pull a bit line down to ground. It will also turn transistor T2 (or T1) on, thereby restoring the bit lines to VDD-VT and ground respectively.

Isolation devices T10, T11, T12 and T13 are used for sense amplifier load isolation. It is used to reduce chip power consumption and to improve the signal to noise ratio of the sense amplifier. During a set latch operation, these isolation devices work like a resistor to reduce bit line voltage drop and speed up the sensing process. With these isolation devices, bit lines are restored only to VDD-VT, instead of VDD. As a result, approximately half the power consumption can be saved.

The gates of the isolation devices can also be connected to a signal which is gated by an address. This can double the bit line signal level and thereby improve the signal/noise ratio of the sense amplifier.

While the preferred embodiment is implemented with a particular type of semiconductor device, it will be understood that the invention can easily be embodied using other semiconductor devices. For example, a p-channel FET can be replaced by a n-channel FET with corresponding changes being made in other parts of the circuit.

## Claims

1. A static random access memory having an array of memory cells (MC) connected to a pair of bit lines (eg, BL1, $\overline{BL1}$) wherefrom data is sensed by sensing means (eg, 5), the memory being characterised by comprising;
dynamic decoding means (8,9) for decoding an address to select a desired memory cell;
means (7) for restoring the decoding means to a predetermined voltage level during the sensing of data; and
means for restoring said bit lines before completion of the address decoding.

2. A static random access memory comprising:
a plurality of memory cells (MC);
a pair of bin lines (eg, BL1, $\overline{BL1}$) connected to the memory cells;
means (eg, 5) for sensing data in the pair of bit lines;
dynamic address decoding means (8,9) for generating a word line signal to select at least one of the memory cells;
decoder restoring means (7) coupled to the decoding means for restoring the decoding means to a predetermined voltage level during the sensing of memory data; and
bit line restoring means coupled to the pair of bit lines for restoring the pair of bit lines to a predetermined voltage level before completion of address decoding.

3. A static random access memory as claimed in claim 2, further comprising driver and latch means coupled to the decoding means for latching the word line signals generated by the decoding means for maintaining the output voltage level of the decoding means despite any leakage in the word line signals.

4. A static random access memory as claimed in claim 2 or claim 3, wherein the bit line restoring means further includes a signal generator which comprises:
a first transistor having a gate activated by a first voltage level to control connection of another voltage level with a first node;
a second transistor having a drain connected to the first node and having a gate activated by a second voltage level;
a third transistor having a gate activated by said second voltage level applied at its gate, the drain of the third transistor being connected to the first node; and
a fourth transistor connected in series with the third transistor at a second node, the fourth transistor having a gate activated by the first voltage level and wherein the gate of the fourth transistor is connected to the first node.

5. A static random access memory as claimed in claim 4, wherein said signal generator further comprises feedback means for maintaining the voltage level of said first node despite any leakage of a charge at said first node.

6. A static random access memory as claimed in claim 5, wherein the feedback means comprises a transistor having one terminal connected to said first node, another terminal connected to a voltage source, and a gate connected so as to be activated by the voltage level at said second node.

7. A memory as claimed in and preceding claim, wherein the bit line restoring means further comprises means for equalising the voltage levels of the bit lines and means for precharging the equalised bit lines to a predetermined voltage level.

8. A method for accessing data in a desired memory cell of a static random access memory having an array of memory cells, each connected to a pair of bit lines wherefrom data is sensed by data sensing means, the method comprising the steps of:
decoding a given cell address using a dynamic type address decoder;
restoring said decoder to a predetermined voltage level during the sensing of data and restoring said pair of bit lines to a predetermined voltage level before completion of address decoding.

FIG. 1

CS CD0 CD1 CD2 PWD CD3 CD5 CSB

VDD

D9 D8 D7 D6 D5 D4 D3 D2 D1

$\overline{CS}$

FIG. 2A

FIG. 2B

FIG. 3

EP 0 317 122 A2

FIG. 4A

FIG. 4B

FIG. 5

EP 0 317 122 A2

FIG. 6